# EUROPEAN PATENT SPECIFICATION

(11) **EP 2 988 328 B1**
(45) Date of publication and mention of the grant of the patent: **12.05.2021**
(21) Application number: 14181407.9
(22) Date of filing: 19.08.2014
(51) Int. Cl.: H01L 23/14, H01L 23/492, H01L 23/538

(54) **Power semiconductor module and method of manufacturing the same**
Leistungshalbleitermodul und Verfahren zur Herstellung davon
Module semi-conducteur de puissance et procédé de fabrication de celui-ci

(43) Date of publication of application: 24.02.2016
(73) Proprietor: ABB Schweiz AG, 5400 Baden (CH)
(72) Inventor: Liu, Chunlei, 5600 Lenzburg, Aargau (CH); Cottet, Didier, 5405 Baden Daettwil (CH); Brem, Franziska, 5405 Baden Daettwil (CH); Kicin, Slavo, 5405 Baden Daettwil (CH)
(74) Representative: Kolster Oy Ab

(56) References cited:
- DE-A1-102010 060 855
- US-A1- 2008 251 903
- US-A1- 2013 221 526
- US-A1- 2014 035 114

## Description

### FIELD OF THE INVENTION

The present invention relates to power semiconductor modules, and particularly to minimizing stray inductance of such modules.

### BACKGROUND INFORMATION

A conventional power semiconductor module typically comprises one or more ceramic substrates on which an electrical circuit (defined in a copper or aluminium metallization layer) has been formed. Semiconductor chips (such as switches and diodes) are typically electrically connected to the electrical circuit through die attach and bonding wires. Power and auxiliary terminals are typically used to provide electrical connections between the module and the outside world. If a very high current rating is required, more substrates may be used in parallel and mounted on a module baseplate. Electrical insulation in the module is usually provided by silicone gel. Mechanical protection may be provided by a plastic housing.

The above-described module concept can provide sufficient performance for exploiting switching capability of conventional silicon-based devices. However, fast switching wide band-gap semiconductors (e.g. silicon-carbide-based semiconductors) are introducing challenges which may be difficult to address with conventional power electronics module design. Due to higher switching frequencies, minimization of stray inductances in the module may be very important. In a conventional power electronics module, it may be difficult to suppress the stray inductances (below 10 nH, for example), since typically there are inductive loops (with a certain loop length and area) in commutation paths due to positioning of the chips, bonding wires, and terminals. Further, achieving balanced switching may require optimization of gate emitter connections from an EMI and EMC point of view, which may be difficult with the conventional module design.

In order to alleviate the described power module limitations, new, more compact module concepts have been proposed. Some of the proposals utilize 3D design of the module.

For example, the semiconductor components may be stacked on top of each other. US patent application US 2013/0329370 A1 describes a half-bridge module having semiconductor components and two or more ceramic substrates stacked on top of each other. With this approach, the distances between the components, and thereby also the length of inductive loops, can be reduced. However, this approach may be complicated to manufacture, and thus, may not be very cost-effective.

Another approach to minimize stray inductances is to utilize printed circuit board technology in the module. Semiconductors may be embedded in a PCB structure, and electrical conductors formed in the PCB may be optimized for minimal stray inductances. US patent applications US 2009/041994 A1 and US2013/199829 A1 and PCT applications WO 2012/072212 A2 and WO 2012/175207 A2 show implementations of embedded chips in PCBs. However, the PCB technology has traditionally been constrained to low-voltage and low-power implementations.

Document US2013/0221526 A1 discloses a method for manufacturing a system in package (SIP). In the disclosure, the SIP is manufactured in a combined process step which means lamination and sintering in a single and common process step.

### BRIEF DISCLOSURE

An object of the present invention is to provide a method and an apparatus for implementing the method so as to alleviate the above disadvantages. The objects of the invention are achieved by a module and a method as defined in the independent claims. Preferred embodiments of the invention are disclosed in the dependent claims.

Extremely low stray inductances in a power semiconductor module may be achieved by embedding chips of the power semiconductors in a printed circuit board (PCB) while also stacking the chips on top of each other. Thus, interconnections between the stacked semiconductor chips may be mostly vertical. Connection terminals for the module may also be at least partially positioned above the embedded semiconductor chips. Further reductions in stray inductances may be achieved by stacking chips in the same commutation loops above each other.

Because of the low stray inductances, over-voltages induced by the stray inductances in a module according to the present disclosure are reduced, and the module can support fast switching. Therefore, the approach may be attractive for fast switching LV (low voltage) applications and allows exploitation switching capabilities of wide-band-gap semiconductors.

The use of the PCB technology enables significant cost reductions and allows high yield and throughput to be achieved in the production line. The module and method according to the present disclosure allow extremely compact design of the power electronics module. Further, control electronics may directly be embedded in or mounted on the PCB.

Another advantage of the module and method according to the present disclosure is their high design flexibility. Since electrical connections are formed in the PCB, customized solutions are more easily implemented. Additionally, the concept allows fabrication of complex 3D structures by using multi-layer PCBs. The concept allows tuning of the switching performance (e.g. optimization of gate-emitter loop) of each chip providing a balanced current flow through all chips, and thus, higher reliability of the module.

### BRIEF DESCRIPTION OF THE DRAWINGS

In the following, the invention will be described in greater detail by means of preferred embodiments and with reference to the attached drawings, in which
Figures 1a to 1c show an exemplary half-bridge circuitry;
Figure 2 shows an exemplary power semiconductor module comprising the half-bridge of Figures 1a to 1c;
Figures 3a to 3d show exemplary, simplified stages of a manufacturing process for a power semiconductor as shown in Figure 2;
Figure 4 shows an example of a possible cooling solution for a module according to the present disclosure; and
Figure 5 shows an example of a double-side cooled, electrically non-insulated power semiconductor module according to the present disclosure.

### DETAILED DISCLOSURE

The present disclosure presents a power semiconductor module with reduced stray inductances, and a method for producing such a module.

In the context of the present disclosure, a power semiconductor module, or alternatively, a power electronics module, refers to a module comprising at least a first semiconductor device and a second semiconductor device which together form a commutation loop. The module may be configured to operate such that, in response to a control signal, a current flowing through one of the semiconductor devices commutates to flow through the other semi-conductor device. For example, one of the semiconductors may be a power semiconductor device, such as an IGBT or a MOSFET, and the other may be a rectifier device, such as a diode. The semiconductors may form a plurality of commutation loops. The power semiconductor module may be a half-bridge module, for example.

A power semiconductor module also comprises a lead frame in which a chip of the first semiconductor device is embedded. The lead frame may be a layer of a conducting material, such as a copper plate, in which a cavity has been formed. The first semiconductor device may be bonded to the cavity through standard module assembly technologies. The module further comprises a first printed circuit board mounted on top of the lead frame and the chip of the first semiconductor device, and a support frame mounted on top of the printed circuit board.

The support frame may comprise a cavity in which the chip of the second semiconductor device is embedded. The first printed circuit layer comprises a first electrically conducting path between the chips of the first semi-conductor device and the second semiconductor device. The chips of the first semiconductor device and the second semi-conductor device are positioned on top of each other. Since the chips overlap, interconnections between them may be essentially vertical (i.e. perpendicular to the planes of the lead frame and the layers of the first PCB), and therefore, very short. The stray inductance can thus be minimized between the semiconductors in the commutation loop.

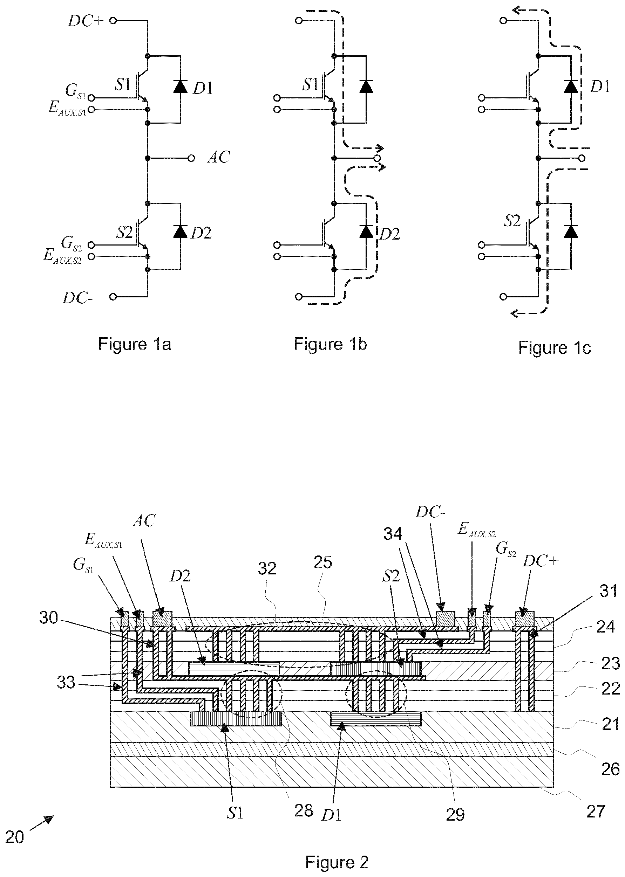

A module according to the present disclosure may form a power semiconductor half-bridge, for example. Figures 1a to 1c show an exemplary half-bridge circuitry and commutation loops it forms. The half-bridge in Figure 1a comprises a first semiconductor switching device *S*1 and a second semi-conductor switching device *S*2 connected in series between a positive terminal DC+ and a negative terminal DC-, a first semiconductor rectifier device *D*1 connected in parallel with the first semiconductor switching device *S*1, and a second semiconductor rectifier device *D*2 connected in parallel with the second semiconductor switching device *D*2*.* In the context of the present disclosure, the term "connected in parallel" refers to a configuration where two (or more) electrical components have each been connected between the same two voltage potentials. This includes anti-parallel-connected components, i.e. components connected in parallel but having reversed polarities.

In Figure 1a, the switches *S*1 and *S*2 are IGBTs. The switches *S*1 and *S*2 are controlled into a conducting state and a non-conducting state on the basis of a voltage between a gate terminal and an auxiliary emitter terminal. Figure 1a shows a gate terminal *G*_{*S*1} and an auxiliary emitter terminal *E_{AUX}, S*1 for the switch *S*1, and a gate terminal *G*_{*S*2} and an auxiliary emitter terminal *E_{AUX}, S*2 for the switch *S*2.

Although Figure 1a illustrates IGBTs, the switches *S*1 and *S*2 may also be other power semiconductor switches, such as power MOSFETs. The rectifier devices *D1* and *D*2 may be freewheeling diodes, for example.

The first switch *S*1 and the first rectifier *D*1 act as first semiconductor devices and the second switch *S*2 and second rectifier *D2* act as second semi-conductor devices. The first switch *S*1 and the second rectifier *D*2 form a first commutation loop, as shown in Figure 1b. The second switch *S*2 and the first rectifier *D*1 form a second commutation loop, as shown in Figure 1c.

Figure 2 shows an exemplary power semiconductor module 20 comprising the half-bridge of Figure 1. Figure 2 shows the power electronics module 20 further comprising a lead frame 21. The lead frame 21 has cavities in its top surface. The cavities are configured to receive chips of the first switch *S*1 and the first rectifier *D*1. Figure 2 shows the chips of the first switching device *S*1 and the first rectifier device *D*1 embedded in the cavities. The lead frame 21 may be made of an electrically conducting material that is suitable to be used in a PCB manufacturing process. The lead frame 21 may be made of copper or aluminium, for example.

A first PCB 22 is mounted on top of the lead frame 21 and the chips of the first switching device *S*1 and the first rectifier device *D*1. The first PCB 22 may be a single PCB layer or a multilayer PCB, for example.

In Figure 2, a support frame 23 is mounted on top of the first PCB 22. The support frame 23 may be made of an insulating material suitable to be used in a PCB manufacturing process, for example. The support frame 23 comprises cavities in which chips of the second switching device *S*2 and the second rectifier device *D*2 are embedded.

In Figure 2, the chips of the first switching device *S*1 and the second rectifier device *D*2 are positioned on top of each other, and the chips of the second switching device *S*2 and the first rectifier device *D*1 are positioned on top of each other.

The power electronics module 20 in Figure 2 further comprises a second PCB 24 formed on top of the support frame 23. Further, the module 20 also comprises a first electrically insulating layer 25 on top of the second PCB 24, and a second electrically insulating layer 26 on the bottom of the lead frame 21. In Figure 2, a base plate 27 is added on the bottom of the second electrically insulating layer 26 to provide mechanical support for the module 20.

The first PCB 22 comprises a first electrically conducting path 28 between the chips of the first switching device *S*1 and the second rectifier device D2, and a second electrically conducting path 29 between the chips of the second switching device S2 and the first rectifier device *D*1. The electrical paths 28 and 29 may be metal-plated throughholes formed by a standard PCB manufacturing process, for example. The electrical paths 28 and 29 may be connected to each other in the first PCB 22. A conductor 30 formed through the support frame 23, the second PCB 24, and the first electrical insulation 25 may be used to connect the electrical paths 28 and 29 to an AC terminal on the top surface of the module.

In the module 20, the first switching device *S*1 and the first rectifier device *D*1 are connected in parallel. A connection between the parallel-connected chips and a positive terminal *DC+* of the module may be provided through the electrically conducting lead frame 21 and an electrically conducting path 31 formed through the first PCB 22, the support frame 23, the second PCB 24, and the first electrical insulation 25.

In the module 20, the second switching device S2 and the second rectifier device D2 are connected in parallel. An electrical connection between the parallel-connected chips of the second switching device S2 and the second rectifier device *D2* and a negative terminal *DC-* of the module may be in the form of an electrically conducting path 32 formed through the second PCB 24 and the first electrical insulation 25.

In addition, the first PCB 22 and the second PCB 24 may comprise conductors for control signals of the switching devices *S*1 and *S*2. In Figure 2, conductors 33 passing through the support frame 23, the second PCB 24, and the first electrical insulation 25 form electrical connections between the control terminals of the first switch *S*1 and the top surface of the module 20. For example, the conductors 33 may be connected to a gate terminal and an auxiliary emitter terminal of the first switching device *S*1. In a similar manner, conductors 34 passing through the second PCB 24 provide electrical connections between the control terminals of the second switch *S*2 and from the top surface of the module 20. Alternatively, the terminals for the control signals may be formed on the sides of the module.

A power semiconductor module according to the present disclosure may be produced by using standard PCB manufacturing processes. In a first stage, a lead frame with a cavity for receiving a chip of the first semiconductor device is formed and the chip of the first semiconductor device is bonded to the cavity. The lead frame may be made of an electrically conducting material compatible with a PCB fabrication process, and the chip of the first semiconductor device may be bonded by using standard module assembly technologies, e.g. sintering, transient liquid phase bonding (TLP) or soldering.

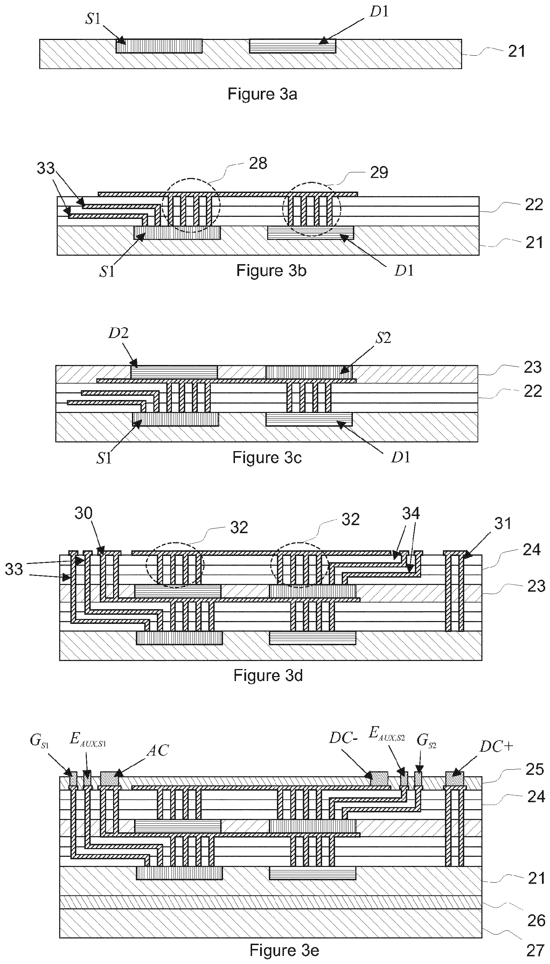

Figures 3a to 3d show an exemplary, simplified stages of a process for manufacturing a power semiconductor as shown in Figure 2. Figure 3a shows a first switch *S*1 and a first rectifier *D*1 bonded to cavities in the lead frame 21. The first switch *S*1 and the first rectifier *D*1 act as first semiconductor devices.

In a second stage, a first PCB is formed on top of the lead frame and the chip of the first semiconductor device. The first PCB may be a single PCB layer or a multi-layer PCB. The final surface of the structure is flat and is suitable for receiving the chip of the second semiconductor device. The first PCB comprises an electrically conducting path between an electrical contact on a top surface of the first PCB and the chip of the first semiconductor device on the bottom side of the first PCB.

Figure 3b shows a first PCB 22 formed on top of the lead frame 21 and the chips of the first switch *S*1 and the first rectifier *D*1. The PCB 22 comprises two conductors 28 and 29 which provide electrical connections from the first switch *S*1 and the first rectifier *D*1 to the top surface of the PCB 22. The electrical paths 28 and 29 may be plated through-holes formed by a standard PCB manufacturing process, for example. In addition, portions of conductors 33 for the control signal of the first switch may be formed in the first PCB 22

In a third stage, a chip of the second semiconductor device is bonded to the electrical contact on the top surface of the first PCB so that the chips of the first semiconductor device and the second semiconductor device are positioned on top of each other. The chips of the second switching device and rectifier device may be attached e.g. by sintering (especially pressure-less sintering) or TLP, for example.

Before or after the bonding of the chip of the second semiconductor device, a support frame is mounted on top of the first PCB. The support frame has a cavity for receiving the chip of the second semiconductor device. The support frame may be compatible with the PCB technology.

Figure 3c shows the second switch *S*2 and the second rectifier *D2* bonded to the electrical contact surface on top of the first PCB 22. The second rectifier *D2* is bonded above the first switch *S*1 and the second switch *S*2 is bonded above the first rectifier *D*1 so that very short electrical current paths are formed. A support frame 23 with cavities for both chips provides a flat surface for subsequent layers.

In a fourth stage, a second PCB is formed on top of the support frame. The second PCB comprises an electrically conducting path between the top surface of the second PCB and the chip of the second semiconductor device on the bottom side of the second PCB. In addition, electrical connections from the top surface of the second PCB to the lead frame, to the control terminals of the first and second switch, and to the AC potential in the module may be formed in this stage by forming plated drillholes/vias.

Figure 3d shows a second PCB 24 attached on top of the support frame 23. In the second PCB 24, an electrically conducting path 32 between the top surface the chip of the second switch *S*2 has been formed. The second PCB 24 also has an electrically conducting path 32 between the top surface and the chip of the second rectifier *D*2. The top surface of the second PCB 24 is metallized for mounting/bonding of power and auxiliary connectors.

Figure 3d also shows an electrically conducting path 31 from the top side of the second PCB 24 to the lead frame 21 which represents positive potential DC+, and an electrically conducting path 30 to the AC potential at the top layer of the first PCB 22.

In Figure 3d, electrical connections 33 between the top layer of the second PCB 24 and the control terminals of the chip of the first switch are completed with vertical portions which can be formed as plated drillholes/vias. In Figure 3d, the plated vias are formed through the second PCB 24, the support frame 23, and part of the first PCB 22. Alternatively, the first PCB 22 may be formed such that the portions of connections 33 in the first PCB 22 already lead to the top surface of the first PCB 22. Thus, vias of equal depths may be formed to finish the connections 33. Electrical connections (e.g. plated vias) through the support frame 23 and/or the second PCB 24 may also be formed before attaching them to the module.

Further, the second PCB 24 comprises electrical conductors 34 leading from the top side of the second PCB 24 to the control terminals of the second switch S2.

In a fifth stage, a first electrically insulating layer may be added on top of the second PCB, and a second electrically insulating layer may be added on the bottom of the lead frame. Further, a base plate may be added on the bottom of the second electrically insulating layer. The first electrically insulating layer may be formed such that it has openings for connection terminals for power and auxiliary connections on the top surface of the formed module. Connectors for the power and auxiliary connections may be added in this stage.

Figure 3e shows a first insulating layer 25 of an electrically insulating material on top of the second PCB 24, and a second insulating layer 26 of an electrically insulating material on the bottom of the lead frame 21. The first insulating layer has openings for contact terminals. Figure 3e shows main power connectors *DC+, DC-, AC,* and control signal connectors *G*_{*S*1}, *E*_{*AUX,S*1}, *GS2, E*_{*AUX,S*2}*.* A base plate 27 made of another layer of metal is attached to the bottom of the second insulating layer 26. The base plate 27 provides mechanical support if more lead frames are used, for example.

A module according to the present disclosure may be embedded with control electronics for controlling the module. The control electronics may be connected to the top layer of the second PCB, for example. The modules may be made application specific. A module may also comprise a plurality of lead frames. Semiconductor chips may be bonded to one or more lead frames and electrical connections between the chips and connection terminals may be provided in the PCB layers according customer requirements. If more than one lead frame is used, they all may be mechanically supported by a single, shared base plate.

Insulation properties of PCBs, desired creepage and clearance distances, and fabrication technology capabilities may affect the range of applications the module can be used for. In more demanding applications, a copper lead frame may be replaced by another material with a lower coefficient for thermal expansion (CTE) and a higher PCB grade may be used. Thus, temperature capability of the module may be increased at a moderate price.

An arrangement comprising a power semiconductor module according to the present disclosure may be cooled from both sides of the module. Heat sinks may be mounted on the top surface of the module and on the bottom surface of the module by using screws, for example. One-sided cooling may result in uneven junction temperatures in the chips embedded in the module structure.

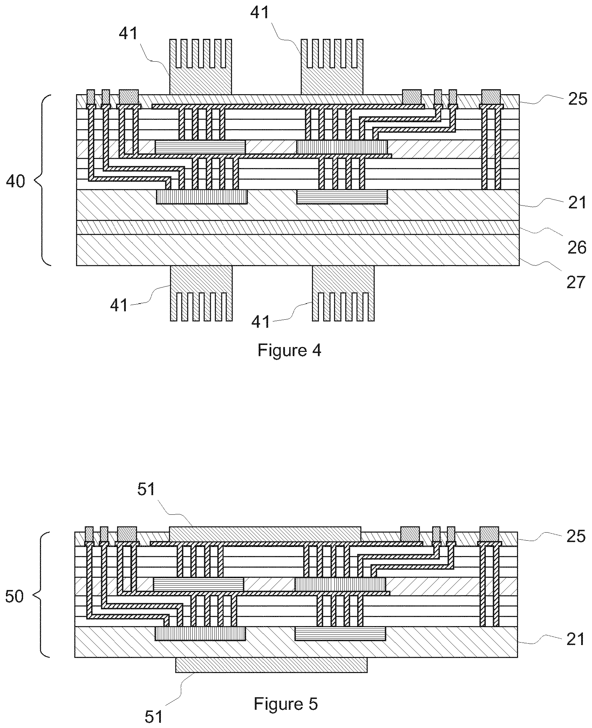

Figure 4 shows an example of a possible cooling solution for the module. A power semiconductor module 40 in Figure 4 may be manufactured as shown in Figures 3a to 3e, for example. Four heat sinks 41 are mounted on the top and bottom surface of the power semiconductor module 40 according to the present disclosure. Two heat sinks 41 are mounted on the top surface of the first insulating layer 25 and two more heat sinks 41 are mounted on the bottom surface of the base plate 27. Since the second insulating layer 26 separates the base plate 27 from the lead frame 21, the heat sinks 41 may be galvanically isolated from the first and second switches and the first and second rectifiers.

Alternatively, a non-insulated module may be used, and cooling means may be directly connected to potentials DC+ and DC-. Figure 5 shows an example of a double-side cooled, electrically non-insulated power semiconductor module 50 according to the present disclosure. The module 50 may be manufactured as shown in Figures 3a to 3d. However, in contrast to the above examples, the base plate and the second insulating layer may be omitted and the first insulating layer 25 may have a larger opening. In this manner, the non-insulated surfaces may serve as electrical interfaces for the positive and negative DC potentials while, at the same time, serving as cooling interfaces. Figure 5 shows contactors 51 mounted directly on the exposed metal surfaces of the module 50. The contactors 51 may be pressback contacts, for example.

It will be obvious to a person skilled in the art that the inventive concept can be implemented in various ways. The invention and its embodiments are not limited to the examples described above but may vary within the scope of the claims.

## Claims

1. A power electronics module comprising a first semiconductor device (S1, D1) and a second semiconductor device (S2, D2), wherein the module is configured to operate such that, in response to a control signal, a current flowing through one of the semiconductor devices commutates to flow through the other semiconductor device, wherein the power electronics module further comprises
a lead frame (21) in which a chip of the first semiconductor device is embedded,
a first PCB (22) mounted on top of the lead frame (21) and the chip of the first semiconductor device, and
a support frame (23) mounted on top of the first PCB (22), wherein a chip of the second semiconductor device is embedded in the support frame (23), and
wherein
the chips of the first semiconductor device (S1, D1) and the second semiconductor device (S2, D2) are positioned on top of each other,
the first PCB (22) comprises a first electrically conducting path (28) between the chips of the first semiconductor device (S1, D1) and the second semiconductor device (S2, D2), wherein the power electronics module further comprises a second PCB (24) formed on top of the support frame (23), wherein the second PCB provides an electrical connection between a top surface of the second PCB and the chip of the second semiconductor device (S2 D2) on a bottom side of the second PCB.

2. A power electronics module according to claim 1, the power electronics module comprising a first semiconductor switch (S1) and a second semiconductor switch (S2) connected in series, a first semiconductor rectifier (D1) connected in parallel with the first switch (S1), and a second semiconductor rectifier (D2) connected in parallel with the second switch (S2), wherein the first switch and the first rectifier act as first semiconductor devices and the second switch and second rectifier act as second semiconductor devices, and wherein
the chips of the first switch and the first rectifier are embedded in cavities in a top surface of the lead frame (21),
the first PCB (22) is mounted on top of the lead frame (21) and the chips of the first switch and the first rectifier, and
the chips of the second switch and the second rectifier are embedded in cavities in the support frame (23),
the chips of the first switch and the second rectifier are positioned on top of each other,
the chips of the second switch and the first rectifier are positioned on top of each other, and
the first PCB (22) comprises a first electrically conducting path between the chips of the first switch and the second rectifier and a second electrically conducting path between the chips of the second switch and the first rectifier.

3. A power electronics module according to claim 1, wherein the power electronics module further comprises a first electrically insulating layer (25) on top of the second PCB (24), and a second electrically insulating layer on the bottom of the lead frame (26).

4. A power electronics module according to claim 3, wherein the power electronics module further comprises a base plate on the bottom of the second electrically insulating layer.

5. A power electronics module as claimed in any one of preceding claims, wherein the module comprises a plurality of lead frames.

6. An arrangement comprising a power electronics module as claimed in any one of preceding claims, and heat sinks mounted on both sides of the power electronics module.

7. An arrangement comprising a power electronics module as claimed in any of the preceding claims 1 to 5, wherein cooling means are directly connected to DC potentials of the power electronics module.

8. A method for producing a power electronics module comprising a first semiconductor device (S1, D1) and a second semiconductor device (S2, D2), wherein the module is configured to operate such that, in response to a control signal, a current flowing through one of the semiconductor devices commutates to flow through the other semiconductor device, wherein the method comprises
forming a lead frame (21) with a cavity for receiving a chip of the first semiconductor device,
bonding the chip of the first semiconductor device to the cavity,
forming a first PCB (22) on top of the lead frame and the chip of the first semiconductor device, the first PCB comprising a first electrically conducting path between an electrical contact on a top surface of the first PCB and the chip of the first semiconductor device on a bottom side of the first PCB,
bonding a chip of the second semiconductor device to the electrical contact on the top surface of the first PCB so that the chips of the first semi-conductor device and the second semiconductor device are positioned on top of each other, and,
before or after the bonding of the chip of the second semiconductor device, mounting a support frame (23) on top of the first PCB, wherein the support frame has a cavity for receiving the chip of the second semiconductor device, wherein the method further comprises forming a second PCB (23) on top of the support frame, the second PCB comprising a second electrically conducting path between a top surface of the second PCB and the chip of the second semiconductor device on a bottom side of the second PCB.

## Patentansprüche

1. Leistungselektronikmodul, eine erste Halbleitervorrichtung (S1, D1) und eine zweite Halbleitervorrichtung (S2, D2) umfassend, wobei das Modul dafür konfiguriert ist, derart zu arbeiten, dass in Reaktion auf ein Steuersignal ein Strom, der durch eine der Halbleitervorrichtungen fließt, umgeschaltet wird, um durch die andere Halbleitervorrichtung zu fließen, wobei das Leistungselektronikmodul ferner umfasst:
einen Leiterrahmen (21), in den ein Chip der ersten Halbleitervorrichtung eingebettet ist,
eine erste PCB (22), die auf die Oberseite des Leiterrahmens (21) und den Chip der ersten Halbleitervorrichtung montiert ist, und
einen Stützrahmen (23), der auf die Oberseite der ersten PCB (22) montiert ist, wobei in den Stützrahmen (23) ein Chip der zweiten Halbleitervorrichtung eingebettet ist, und
wobei:
die Chips der ersten Halbleitervorrichtung (S1, D1) und der zweiten Halbleitervorrichtung (S2, D2) übereinander positioniert sind,
die erste PCB (22) einen ersten elektrisch leitenden Weg (28) zwischen den Chips der ersten Halbleitervorrichtung (S1, D1) und der zweiten Halbleitervorrichtung (S2, D2) umfasst, wobei das Leistungselektronikmodul ferner eine zweite PCB (24) umfasst, die auf der Oberseite des Stützrahmens (23) gebildet ist, wobei die zweite PCB eine elektrische Verbindung zwischen einer Oberseite der zweiten PCB und dem Chip der zweiten Halbleitervorrichtung (S2, D2) auf einer Unterseite der zweiten PCB bereitstellt.

2. Leistungselektronikmodul nach Anspruch 1, wobei das Leistungselektronikmodul einen ersten Halbleiterschalter (S1) und einen zweiten Halbleiterschalter (S2) umfasst, die in Reihe geschaltet sind, einen ersten Halbleitergleichrichter (D1), der parallel mit dem ersten Schalter (S1) geschaltet ist, und einen zweiten Halbleitergleichrichter (D2), der parallel mit dem zweiten Schalter (S2) geschaltet ist, wobei der erste Schalter und der erste Gleichrichter als erste Halbleitervorrichtungen dienen und der zweite Schalter und der zweite Gleichrichter als zweite Halbleitervorrichtungen dienen und wobei:
die Chips des ersten Schalters und des ersten Gleichrichters in Hohlräume in einer Oberseite des Leiterrahmens (21) eingebettet sind,
die erste PCB (22) auf die Oberseite des Leiterrahmens (21) und die Chips des ersten Schalters und des ersten Gleichrichters montiert ist, und
die Chips des zweiten Schalters und des zweiten Gleichrichters in Hohlräume des Stützrahmens (23) eingebettet sind,
die Chips des ersten Schalters und des zweiten Gleichrichters übereinander positioniert sind,
die Chips des zweiten Schalters und des ersten Gleichrichters übereinander positioniert sind und
die erste PCB (22) einen ersten elektrisch leitenden Weg zwischen den Chips des ersten Schalters und des zweiten Gleichrichters und einen zweiten elektrisch leitenden Weg zwischen den Chips des zweiten Schalters und des ersten Gleichrichters umfasst.

3. Leistungselektronikmodul nach Anspruch 1, wobei das Leistungselektronikmodul ferner eine erste elektrisch isolierende Schicht (25) auf der Oberseite der zweiten PCB (24) und eine zweite elektrisch isolierende Schicht auf der Unterseite des Leiterrahmens (26) umfasst.

4. Leistungselektronikmodul nach Anspruch 3, wobei das Leistungselektronikmodul ferner eine Grundplatte auf der Unterseite der zweiten elektrisch isolierenden Schicht umfasst.

5. Leistungselektronikmodul nach einem der vorhergehenden Ansprüche, wobei das Modul mehrere Leiterrahmen umfasst.

6. Anordnung, ein Leistungselektronikmodul nach einem der vorhergehenden Ansprüche und Kühlkörper umfassend, die an beiden Seiten des Leistungselektronikmoduls montiert sind.

7. Anordnung, ein Leistungselektronikmodul nach einem der Ansprüche 1 bis 5 umfassend, wobei Kühlungsmittel direkt mit Gleichstrompotentialen des Leistungselektronikmoduls verbunden sind.

8. Verfahren zum Herstellen eines Leistungselektronikmoduls, das eine erste Halbleitervorrichtung (S1, D1) und eine zweite Halbleitervorrichtung (S2, D2) umfassend, wobei das Modul dafür konfiguriert ist, derart zu arbeiten, dass in Reaktion auf ein Steuersignal ein Strom, der durch eine der Halbleitervorrichtungen fließt, umgeschaltet wird, um durch die andere Halbleitervorrichtung zu fließen, wobei das Verfahren umfasst:
Bilden eines Leiterrahmens (21) mit einem Hohlraum für die Aufnahme eines Chips der ersten Halbleitervorrichtung,
Bonden des Chips der ersten Halbleitervorrichtung an den Hohlraum,
Bilden einer ersten PCB (22) auf der Oberseite des Leiterrahmens und des Chips der ersten Halbleitervorrichtung, wobei die erste PCB einen ersten elektrisch leitenden Weg zwischen einem elektrischen Kontakt auf einer Oberseite der ersten PCB und dem Chip der ersten Halbleitervorrichtung auf einer Unterseite der ersten PCB umfasst,
Bonden eines Chips der zweiten Halbleitervorrichtung an den elektrischen Kontakt auf der Oberseite der ersten PCB derart, dass die Chips der ersten Halbleitervorrichtung und der zweiten Halbleitervorrichtung übereinander positioniert werden, und
Montieren eines Stützrahmens (23) auf die Oberseite der ersten PCB vor oder nach dem Bonden des Chips der zweiten Halbleitervorrichtung, wobei der Stützrahmen einen Hohlraum zur Aufnahme des Chips der zweiten Halbleitervorrichtung aufweist, wobei das Verfahren ferner das Bilden einer zweiten PCB (23) auf der Oberseite des Stützrahmens umfasst, wobei die zweite PCB einen zweiten elektrisch leitenden Weg zwischen einer Oberseite der zweiten PCB und dem Chip der zweiten Halbleitervorrichtung auf einer Unterseite der zweiten PCB umfasst.

## Revendications

1. Module d'électronique de puissance, comprenant un premier dispositif à semi-conducteur (S1, D1) et un deuxième dispositif à semi-conducteur (S2, D2), le module étant configuré pour fonctionner de telle manière que, en réponse à un signal de commande, un courant circulant dans l'un des dispositifs à semi-conducteur commute pour circuler dans l'autre dispositif à semi-conducteur, le module d'électronique de puissance comprenant en outre
une grille de connexion (21) dans laquelle est noyée une puce du premier dispositif à semi-conducteur,
une première PCB (22) montée sur le dessus de la grille de connexion (21) et de la puce du premier dispositif à semi-conducteur, et
une grille de support (23) montée sur le dessus de la première PCB (22), une puce du deuxième dispositif à semi-conducteur étant noyée dans la grille de support (23), et
les puces du premier dispositif à semi-conducteur (S1, D1) et du deuxième dispositif à semi-conducteur (S2, D2) étant positionnées l'une au-dessus de l'autre,
la première PCB (22) comprenant un premier chemin électriquement conducteur (28) entre les puces du premier dispositif à semi-conducteur (S1, D1) et du deuxième dispositif à semi-conducteur (S2, D2), le module d'électronique de puissance comprenant en outre une deuxième PCB (24) formée sur le dessus de la grille de support (23), la deuxième PCB fournissant une liaison électrique entre une surface de dessus de la deuxième PCB et la puce du deuxième dispositif à semi-conducteur (S2, D2) sur une face de dessous de la deuxième PCB.

2. Module d'électronique de puissance selon la revendication 1, le module d'électronique de puissance comprenant un premier interrupteur à semi-conducteur (S1) et un deuxième interrupteur à semi-conducteur (S2) montés en série, un premier redresseur à semi-conducteur (D1) monté en parallèle avec le premier interrupteur (S1) et un deuxième redresseur à semi-conducteur (D2) monté en parallèle avec le deuxième interrupteur (S2), le premier interrupteur et le premier redresseur jouant le rôle de premiers dispositifs à semi-conducteur et le deuxième interrupteur et le deuxième redresseur jouant le rôle de deuxièmes dispositifs à semi-conducteur, et
les puces du premier interrupteur et du premier redresseur étant noyées dans des cavités dans une surface de dessus de la grille de connexion (21),
la première PCB (22) étant montée sur le dessus de la grille de connexion (21) et des puces du premier interrupteur et du premier redresseur, et
les puces du deuxième interrupteur et du deuxième redresseur étant noyées dans des cavités dans la grille de support (23),
les puces du premier interrupteur et du deuxième redresseur étant positionnées l'une au-dessus de l'autre,
les puces du deuxième interrupteur et du premier redresseur étant positionnées l'une au-dessus de l'autre, et
la première PCB (22) comprenant un premier chemin électriquement conducteur entre les puces du premier interrupteur et du deuxième redresseur et un deuxième chemin électriquement conducteur entre les puces du deuxième interrupteur et du premier redresseur.

3. Module d'électronique de puissance selon la revendication 1, lequel module d'électronique de puissance comprend en outre une première couche électriquement isolante (25) sur le dessus de la deuxième PCB (24) et une deuxième couche électriquement isolante sur le dessous de la grille de connexion (26).

4. Module d'électronique de puissance selon la revendication 3, lequel module d'électronique de puissance comprend en outre une embase sur le dessous de la deuxième couche électriquement isolante.

5. Module d'électronique de puissance selon l'une quelconque des revendications précédentes, lequel module comprend une pluralité de grilles de connexion.

6. Agencement comprenant un module d'électronique de puissance selon l'une quelconque des revendications précédentes et des dissipateurs thermiques montés des deux côtés du module d'électronique de puissance.

7. Agencement comprenant un module d'électronique de puissance selon l'une quelconque des revendications 1 à 5, des moyens de refroidissement étant directement reliés à des potentiels continus du module d'électronique de puissance.

8. Procédé de fabrication d'un module d'électronique de puissance comprenant un premier dispositif à semi-conducteur (S1, D1) et un deuxième dispositif à semi-conducteur (S2, D2), le module étant configuré pour fonctionner de telle manière que, en réponse à un signal de commande, un courant circulant dans l'un des dispositifs à semi-conducteur commute pour circuler dans l'autre dispositif à semi-conducteur, le procédé comprenant
la formation d'une grille de connexion (21) pourvue d'une cavité destinée à recevoir une puce du premier dispositif à semi-conducteur,
l'attache de la puce du premier dispositif à semi-conducteur à la cavité,
la formation d'une première PCB (22) sur le dessus de la grille de connexion et de la puce du premier dispositif à semi-conducteur, la première PCB comprenant un premier chemin électriquement conducteur entre un contact électrique sur une surface de dessus de la première PCB et la puce du premier dispositif à semi-conducteur sur une face de dessous de la première PCB,
l'attache d'une puce du deuxième dispositif à semi-conducteur au contact électrique sur la surface de dessus de la première PCB de telle manière que les puces du premier dispositif à semi-conducteur et du deuxième dispositif à semi-conducteur soient positionnées l'une au-dessus de l'autre, et,
avant et après l'attache de la puce du deuxième dispositif à semi-conducteur, le montage d'une grille de support (23) sur le dessus de la première PCB, la grille de support étant pourvue d'une cavité destinée à recevoir la puce du deuxième dispositif à semi-conducteur, le procédé comprenant en outre la formation d'une deuxième PCB (23) sur le dessus de la grille de support, la deuxième PCB comprenant un deuxième chemin électriquement conducteur entre une surface de dessus de la deuxième PCB et la puce du deuxième dispositif à semi-conducteur sur une face de dessous de la deuxième PCB.
